# EUROPÄISCHE PATENTSCHRIFT

(11) **EP 2 095 411 B1**
(45) Veröffentlichungstag und Bekanntmachung des Hinweises auf die Patenterteilung: **13.02.2013**
(21) Anmeldenummer: 07856184.2
(22) Anmeldetag: 20.11.2007
(51) Int. Cl.: H01L 21/67, H01L 21/677, H01L 31/18

(54) **Produktionsanlage zur Herstellung von Solarzellen im Inline Verfahren, sowie Verfahren zur Integration eines Batch-Prozesses in eine mehrspurige Inline-Produktionsanlage für Solarzellen**
Production plant for manufacturing solar cells in an inline process and method for integrating a batch process into a multi-lane inline production plant for solar cells
Dispositif de production pour la fabrication de cellules solaires au moyen du procédé continu et procédé d'intégration d'un procédé discontinu dans un dispositif de production continu à plusieurs rangées d'un dispositif de production de cellules solaires

(30) Priorität: 20.11.2006 DE 102006054846
(43) Veröffentlichungstag der Anmeldung: 02.09.2009
(73) Patentinhaber: Permatecs GmbH, 78655 Dunningen (DE)
(72) Erfinder: SCHNEIDER, Beate, 78662 Bösingen (DE); SCHNEIDER, Manfred, 78662 Bösingen (DE)
(74) Vertreter: Witte, Weller & Partner
(86) Internationale Anmeldenummer: PCT/EP2007/010001
(87) Internationale Veröffentlichungsnummer: WO 2008/061689

(56) Entgegenhaltungen:
- DE-A1- 3 917 895
- JP-A- 2005 235 916

## Beschreibung

Die Erfindung betrifft eine Produktionsanlage zur Herstellung von Solarzellen im Inline-Verfahren, mit einer Transporteinrichtung zum Transport von einzelnen Zellen in mehreren parallelen Spuren, sowie ein Verfahren zur Integration eines Batchprozesses in eine mehrspurige Inline-Produktionsanlage für Solarzellen.

Produktionsanlagen zur Herstellung von Solarzellen sind allgemein bekannt. Sie umfassen eine Vielzahl von unterschiedlichen Anlagenteilen, die bestimmte chemische oder mechanische Bearbeitungen an Wafern (nachfolgend auch Zellen genannt) vornehmen. Hierzu gehören bspw. die Oberflächenstrukturierung des Wafers (Textur), das Behandeln mit Wärme in einem Diffusionsofen, oder bspw. ein Beschichten mit einer nicht reflektierenden Beschichtung, um nur einige zu nennen.

Im Hinblick auf den Transport von Zellen durch die Produktionsanlage gibt es zwei unterschiedliche Lösungswege, nämlich einerseits das sog. Inline-Verfahren und andererseits das Batch-Verfahren.

Aus der US 5 246 524 A ist eine Produktionsanlage zur Herstellung von Halbleiterwafern mit einer Inline-Batch-Vorrichtung und einer Batch-Inline-Umsetzvorrichtung bekannt. Dabei werden jedoch bei der Umsetzung vom Inline- zum Batch-Prozess und der darauf folgenden Umsetzung vom Batch- zum Inline-Prozess unterschiedliche Träger verwendet.

Die WO 03/038 869 A2 offenbart ein Transportsystem für Wafer, wobei ein Träger von einer Hubeinrichtung durch eine Übergabeeinrichtung übernommen wird und an ein Batch-Prozess-Anlagenteil übergeben wird.

Weiter Produktionsanlagen sind aus US 4,353,160 A, US 4,313,254 A und JP 2004319889 A bekannt.

Arbeitet eine Produktionsanlage im Inline-Verfahren werden die Zellen einzeln in einer Reihe hintereinander durch die Anlage transportiert. Um den Durchsatz zu erhöhen, werden mittlerweile mehrere Reihen von Zellen nebeneinander gleichzeitig transportiert. Es handelt sich hierbei um ein mehrspuriges Inline-Verfahren.

Im Gegensatz hierzu werden die Zellen im Batch-Verfahren nicht einzeln auf einem Transportband, etc. aufliegend durch die Anlage transportiert, sondern mit Hilfe eines sog. Carriers (nachfolgend auch Träger genannt), in dem eine Vielzahl von Zellen eingestapelt sind. Dieser Träger wird über entsprechende Handlingseinheiten durch die einzelnen Anlagenteile transportiert.

Bestimmte Verfahrensschritte sind aus technischen Gründen nur im Inline-Verfahren oder im Batch-Verfahren durchzuführen. So erfolgt bspw. die Strukturierung von monokristallinen Wafern alkalisch im Batch-Verfahren, während multikristalline Wafer bevorzugt im Inline-Verfahren durch saure Behandlung eine Oberflächenstrukturierung erhalten. Der Wirkungsgrad lässt sich dadurch gegenüber einer alkalischen Behandlung erhöhen.

Für Hersteller von Solarzellen ergibt sich dadurch die Notwendigkeit, zwei unterschiedliche Produktionsanlagen zu betreiben, .wenn sowohl monokristalline als auch multikristalline Wafer zu Solarzellen verarbeitet werden sollen. Die Investitionskosten für zwei unterschiedliche Produktionsanlagen sind hoch und stellen gerade für kleinere Firmen ein erhebliches wirtschaftliches Risiko dar, sofern die Auslastung beider Anlagen nicht gesichert ist. Die Konzentration auf eine Produktionsanlage schränkt jedoch die Flexibilität des Herstellers ein, so dass nicht ausreichend schnell auf Kundenwünsche eingegangen werden kann.

Vor diesem Hintergrund besteht die Aufgabe der vorliegenden Erfindung darin, eine Produktionsanlage vorzusehen, der diese Nachteile nicht mehr anhaften. Insbesondere soll die Produktionsanlage flexibel einsetzbar sein, die Investitionskosten gering halten und dennoch die Möglichkeit geben, schnell auf unterschiedliche Kundenwünsche zu reagieren.

Diese Aufgabe wird von der eingangs genannten Produktionsanlage zur Herstellung von Solarzellen gemäß Anspruch 1 dadurch gelöst, dass eine Inline-Batch-Umsetzeinrichtung vorgesehen ist, die ausgelegt ist, Zellen aus den parallelen Spuren gleichzeitig in einen Träger einzubringen und die Zellen jeweils einer Spur übereinander in diesem Träger einzustapeln und dass eine Batch-Inline-Umsetzeinrichtung vorgesehen ist, die ausgelegt ist, die Zellen aus diesem Träger auszubringen und auf zumindest eine Spur einer Transporteinrichtung zu führen.

Das heißt mit anderen Worten, dass die Produktionsanlage eine Kombination von Inline- und Batch-Verfahren zulässt, so dass bspw. eine alkalische Strukturierung von monokristallinen Wafern in einer Inline-Anlage möglich wird. Die einzelnen Zellen mehrerer Spuren werden erfindungsgemäß mit Hilfe der Inline-Batch-Umsetzeinrichtung in einen Carrier oder Träger eingehortet. Der Träger lässt sich dann im Batch-Verfahren durch den sich anschließenden Anlageteil transportieren. Am Ende dieses Anlagenteils befindet sich die Batch-Inline-Umsetzeinrichtung, die die Zellen aus diesem Träger wieder herausnimmt und je nach nachfolgendem Anlagenteil diese Zellen entweder auf eine einzelne Spur oder auf mehrere Spuren führt.

Da die Zellen mehrerer Spuren gleichzeitig in entsprechende Spalten des Trägers in der Inline-Batch-Umsetzeinrichtung eingeführt werden, sind die Handlingsmaßnahmen minimal, so dass die Gefahr von Beschädigungen der sehr empfindlichen Zellen reduziert wird. Es ist inbesondere nicht erforderlich, mit Hilfe von Greifrobotern die Zellen von den mehreren Spuren abzunehmen und in einen Träger übereinander einzustapeln.

Insgesamt erhöht die erfindungsgemäße Produktionsanlage die Flexibilität beim Anlagenbetreiber, da er mit einer einzigen Anlage Inline- und Batch-Verfahren kombinieren kann, Er muss folglich nicht mehr zwei eigenen Produktionsanlagen bereitstellen, solange die Auslastung nicht ausreichend gesichert ist. Damit können die Investitionskosten gerade bei jungen Firmen, die mit der Produktion von Solarzellen beginnen, gering gehalten werden, ohne dass es zu Einschränkungen bei der Angebotspalette käme.

Bei einer bevorzugten Weiterbildung ist zwischen Inline-Batch-Umsetzeinrichtung und Batch-Inline-Umsetzeinrichtung ein Batchprozess-Anlagenteil zur Ausführung eines Batchprozesses vorgesehen, wobei hierfür der Träger mit den Zellen durch den Batchprozess-Anlagenteil transportiert wird. Weiter bevorzugt ist dem Batchprozess-Anlagenteil eine Bypass-Transporteinrichtung zugeordnet, die zur wahlweisen Überbrückung des Batchprozess-Anlagenteils ausgelegt ist, so dass die Zellen keine Behandlung in diesem Batchprozess-Anlagenteil erfahren.

Das heißt mit anderen Worten, dass die Produktionsanlage einen Anlagenteil zur Ausführung eines Batchprozesses aufweist, der jedoch, sofern kein Batchprozess gewünscht ist, mit Hilfe der Bypass-Transporteinrichtung überbrückt werden kann. Diese Bypass-Transporteinrichtung ist bspw. so wie die Transporteinrichtung zum Transport von einzelnen Zellen in mehreren parallelen Spuren vor der Inline-Batch-Umsetzeinrichtung ausgebildet und kann vorzugsweise automatisch auf den Anlagenteil gesetzt werden. Zudem wird die Inline-Batch-Umsetzeinrichtung in einen Bypass-Modus geschaltet, bei dem keine Zellen in einen Träger eingehortet werden, sondern von der vorgelagerten Transporteinrichtung zur Bypass-Transporteinrichtung direkt geführt werden.

Diese Maßnahme hat den Vorteil, dass die Flexibilität der Produktionsanlage weiter steigt, insbesondere auch deshalb, weil bestimmte Anlagenteile, die für Batchprozesse und Inline-Prozesse gleich sind, gemeinsam verwendet werden können. Auch in einem Batchprozess sind bspw. Reinigungs-, Spül- oder Trocknungsvorgänge wie im Inline-Prozess erforderlich. Die gemeinsame Nutzung solcher Teile hat zur Folge, dass der Batchprozess-Anlagenteil in der erfindungsgemäßen Produktionsanlage kleiner ausfallen kann, da bereits vorhandene Teile der Produktionsanlage verwendet werden können.

Besonders vorteilhaft lässt sich die erfindungsgemäße Produktionsanlage dann einsetzen, wenn der Batchprozess-Anlagenteil zwischen Inline-Batch-Uinsetzeinrichtung und Batch-Inline-Umsetzeinrichtung zur alkalischen Oberflächenstrukturierung der.Zellen dient.

Es ist jedoch anzumerken, dass auch andere Batchprozesse möglich sind, wie bspw. eine galvanische Behandlung, Reinigung und Spülung und/oder Trocknung der Zellen. Die Erfindung soll nicht auf den Batchprozess zur alkalischen Oberflächenstrukturierung beschränkt sein.

Bei einer bevorzugten Weiterbildung ist eine Träger-Transporteinrichtung vorgesehen, um den Träger durch den Batchprozess-Anlagenteil zu transportieren. Besonders bevorzugt ist es, die Träger-Transporteinrichtung mit einer Transporteinheit zu versehen, die in einem Becken vorgesehen ist, um den Träger durch dieses zu transportieren.

Das heißt mit anderen Worten, dass der Träger - nicht wie bisher - in ein Becken eingesetzt, aus diesem herausgehoben und in das nachfolgende Becken gesetzt wird, sondern dass vielmehr der Träger durch ein längeres Becken transportiert wird. Der Träger kann hierfür bspw, auf Transportrollen am Boden des Beckens aufliegen und gefördert werden.

An dieser Stelle sei angemerkt, dass gerade dieses Merkmal, nämlich der Transport eines Trägers in horizontaler Richtung durch ein Becken auch alleine ohne die zuvor erwähnte Inline-Batch-Umsetzeinrichtung und die Batch-Inline-Umsetzeinrichtung eingesetzt werden kann.

Bei einer bevorzugten Weiterbildung ist den Umsetzeinrichtungen jeweils eine Träger-Schwenkeinrichtung zugeordnet, um den Träger um einen vorbestimmten Winkel, vorzugsweise 90°, zu schwenken, so dass die Zellen in einer vertikalen Ausrichtung durch den Batchprozess-Anlagenteil transportiert werden.

Diese Maßnahme hat den Vorteil, dass auch Batchprozesse möglich sind, die eine vertikale Ausrichtung der Zellen im Träger erfordern. Die Flexibilität lässt sich dadurch weiter erhöhen. Ein gewisser Nachteil gegenüber der horizontalen Lage der Zellen besteht jedoch darin, dass der Druck auf die Kanten der zellen größer wird und die Gefahr von Beschädigungen steigt.

Bei einer bevorzugten Weiterbildung ist eine Rücktransporteinrichtung vorgesehen, um die Träger von der Batch-Inline-Umsetzeinrichtung zurück zur Inline-Batch-Umsetzeinrichtung zu transportieren.

Das heißt mit anderen Worten, dass die Träger automatisch zurückgeführt weiden, nachdem die Zellen herausgenommen wurden. Bei Bedarf kann der Träger beim Rücktransport gedreht bzw. geschwenkt werden, um die gewünschte Position in der Inline-Batch-Umsetzeinrichtung zu haben.

Bei einer bevorzugten Weiterbildung weist die Inline-Batch-Umsetzeinrichtung Bänder, Riemen, Rollen oder Ketten auf, um die Zellen in den Träger einzubringen

Diese Art des Eintransports der Zellen in den Träger hat sich als besonders vorteilhaft herausgestellt, da die Gefahr von Beschädigungen sehr gering ist.

In einer bevorzugten Weiterbildung weist die Inline-Batch-Umsetzvorrichtung ein Handlingsystem auf, um die Zellen in den Träger einzubringen. Das Handlingssystem erhöht die Flexibilität des gesamten Systems, hat jedoch den Nachteil, dass die Gefahr von Beschädigungen gegenüber dem Transport auf Bändern oder Riemen etc. steigt.

In einer besonders vorteilhaften Weiterbildung weist die Inline-Batch-Umsetzvorrichtung zum Einbringen der Zellen in den Träger flüssige oder gasförmige Medien auf. Damit verringert sich die Gefahr von Beschädigungen der Zellen deutlich.

Schließlich ist es auch denkbar, dass die Inline-Batch-Umsetzvorrichtung einen in Richtung der Zellen verschiebbaren Träger aufweist, um die Zellen in den Träger einzubringen.

Die erfindungsgemäße Produktionsanlage umfasst zumindest einen Träger, der mehrere nebeneinanderliegende Spalten für Zellen mehrerer Spuren aufweist und jede Spalte mehrere Zeilen aufweist, um mehrere Zellen pro Spalte zu stapeln.

Das heißt mit anderen Worten, dass der Träger matrixartig aufgebaut ist, wobei die Anzahl der Spalten der Anzahl der Spuren der Transporteinrichtung im Inline-Anlagenteil entspricht und die Zahl der Zeilen, d.h. der übereinander zu stapelnden Zellen, so gewählt wird, dass eine Verarbeitung im Batchprozess-Anlagenteil noch möglich ist.

Bei einer bevorzugten Weiterbildung ist der Träger derart ausgebildet, dass er sowohl von der Vorderseite als auch von der Rückseite beladen oder entladen werden kann. Diese Maßnahme hat den Vorteil, dass das Handling vereinfacht wird, da der Träger zum Entladen nicht gedreht werden muss.

Bei einer bevorzugten Weiterbildung ist der Träger so ausgebildet, dass die Zellen lediglich an ihren seitlichen Randbereichen abgestützt sind.

Diese Maßnahme hat den Vorteil, dass die Belastung auf die Zellen gering ist, so dass sich die Gefahr von Beschädigungen reduzieren lässt.

Eine Inline-Batch-Umsetzeinrichtung für eine Produktionsanlage zur Herstellung von Solarzellen im mehrspurigen Inline-Verfahren weist, eine Hubeinrichtung auf, die ausgelegt ist, einen Träger für Zellen gegenüber einer Zellen-Transportebene anzuheben, eine Transporteinrichtung, die derart ausgebildet ist, dass sie Zellen mehrerer paralleler Spuren gleichzeitig in den Träger transportiert, und eine übergabeeinrichtung zur Übernahme des Trägers von der Hubeinrichtung und zur Übergabe des Trägers an einen Batchprozess-Anlagenteil aufweist.

Bevorzugt umfasst die Übergabeeinrichtung eine Schwenkeinheit, die den Träger vor der Übergabe um 90° dreht, so dass die Zellen im Träger vertikal angeordnet sind.

Es ist weiter bevorzugt, dass die Transporteinrichtung mehrere den einzelnen Spuren zugeordnete Transportbänder aufweist.

Bei einer bevorzugten Weiterbildung ist ein Trägermagazin vorgesehen, das mehrere Träger aufnimmt und aus dem der Hubeinrichtung ein Träger zugeführt wird. Es ist auch bevorzugt, eine Rücktransporteinrichtung vorzusehen, die leere Träger von einer Batch-Inline-Umsetzeinrichtung in das Trägermagazin transportiert, wobei die Rücktransporteinrichtung vorzugsweise eine Einheit zum Schwenken des Trägers in die von der Hubeinrichtung benötigte Lage aufweist.

Eine Batch-Inline-Umsetzeinrichtung für eine Produktionsanlage zur Herstellung von Solarzellen im mehrspurigen Inline-Verfahren weist auf: eine Übergabeeinrichtung zur Übernahme eines Trägers für Zellen von einem Batchprozess-Anlagenteil und zur Übergabe des Trägers an eine Hubeinrichtung, die ausgelegt ist, den Träger gegenüber einer nachfolgenden Zellentransportebene abzusenken, und eine Transporteinrichtung, die derart ausgebildet ist, dass sie Zellen mehrerer paralleler Spuren gleichzeitig aus dem Träger in den nachfolgenden ein- oder mehrspurigen Inline-Prozess-Anlagenteil transportiert.

Bevorzugt umfasst die Übergabeeinrichtung eine Schwenkeinheit, die den Träger vor der Übergabe um 90° dreht, so dass die Zellen im Träger horizontal angeordnet sind. Es ist auch bevorzugt, dass die Transporteinrichtung mehrere den einzelnen Spuren zugeordnete Transportbänder aufweist.

Die der Erfindung zugrunde liegende Aufgabe wird auch von einem Verfahren zur Integration eines Batchprozesses in eine mehrspurige Inline-Produktionsanlage für Solarzellen gemäß Anspruch gelöst, das folgende Schritte aufweist:
- Gleichzeitige Übergabe von Zellen mehrerer Spuren eines Inlineprozess-Anlagenteils in einen matrixantig aufgebauten Träger,
- Anheben oder Absenken des Trägers um eine Position, und Wiederholung des Übergabeschritts, um mehrere Zellen jeweils einer Spur im Träger zu stapeln,
   und
- Übergabe des Trägers an einen nachfolgen Batchprozess-Anlagenteil, insbesondere dann, wenn der Träger voll ist.

Ferner weist das Verfahren noch folgende Schritte auf:
- Übernahme eines Trägers am Ende des Batchprozess-Anlagenteils,
- Positionieren des Trägers relativ zu einer nachfolgenden Transportebene des ein- oder mehrspurigen Inline-Prozessanlagenteils,
- Gleichzeitige Übergabe von Zellen aus einer Ebene des Trägers an die eine Spur oder die mehreren Spuren des Inline-Prozessanlagenteils,
- Absenken oder Anheben des Trägers um eine Position, und Wiederholung des Übergabeschritts um alle Zellen jedes Stapels in dem nachfolgenden Inline-Prozessanlagenteil zuzuführen, und
- Rückführung des leeren Trägers.

Die mit diesem Verfahren einhergehenden Vorteile wurden bereits im Zusammenhang mit der Produktionsanlage beschrieben, so dass auf eine Wiederholung an dieser Stelle verzichtet werden kann.

Bei einer bevorzugten Weiterbildung weist der Batchprozess-Anlagenteil ein Becken zur Behandlung der Zellen auf, wobei der Träger mit den Zellen durch das Becken gefördert wird.

Das heißt mit anderen Worten, dass der Träger in horizontaler Richtung durch ein Behandlungsbecken gefördert wird und erst am Ende des Beckens wieder herausgehoben wird.

Wie zuvor im Zusammenhang mit der erfindungsgemäßen Produktionsanlage bereits angedeutet, kann dieses Verfahren auch ohne das Inline-Batch-Umsetzverfahren alleine eingesetzt werden.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Dies gilt insbesondere für das Merkmal des horizontalen Transports eines Trägers durch ein Becken im Batchprozess-Anlagenteil.

Die Erfindung wird nun anhand von Ausführungsbeispielen unter Bezugnahme auf die Zeichnung detailliert beschrieben. Dabei zeigen:
- Fig. 1: eine schematische Blockdarstellung eines Ausschnitts einer Produktionsanlage für Solarzellen;
- Fig. 2: eine schematische Darstellung des in Fig. 1 gezeigten Anlagenteils von der Seite;
- Fig. 3: eine schematische Darstellung des Anlagenteils von Fig. 1 mit einer zusätzlichen Schwenkeinrichtung;
- Fig. 4: eine schematische perspektivische Darstellung eines Trägers für Zellen;
- Fig. 5: eine schematische Darstellung der Träger beim Be- bzw. Entladen.

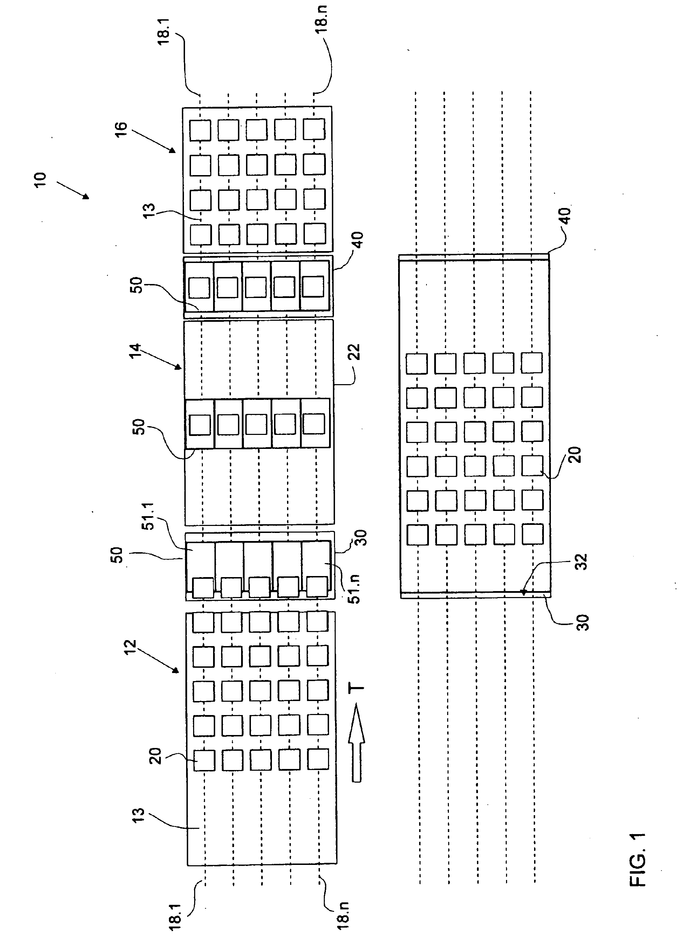

In Fig. 1 ist ein Teil einer Produktionsanlage zur Herstellung von Solarzellen schematisch in Form von Blöcken dargestellt und mit dem Bezugszeichen 10 gekennzeichnet. Der dargestellte Ausschnitt einer Produktionsanlage 10 umfasst einen ersten Anlagenteil 12, einen zweiten Anlagenteil 14 und einen dritten Anlagenteil 16, die hintereinander in Transportrichtung T angeordnet sind.

Der erste Anlagenteil 12 besitzt eine Transporteinrichtung 13, die zu bearbeitende Wafer bzw. Zellen 20 in Transportrichtung T transportiert. Wie deutlich zu erkennen ist, werden die Zellen 20 hintereinander und in mehreren Spuren 18.1 - 18.n kontinuierlich transportiert. Diese Art von Transport wird als mehrspuriger Inline-Transport bezeichnet und in Produktionsanlagen benutzt, die sog. Inline-Prozesse ausführen. Bei solchen Inline-Prozessen wandern die Zellen kontinuierlich mehrspurig und hintereinander durch die Anlagenteile, die im Allgemeinen bekannt sind, so dass darauf nicht weiter eingegangen werden soll. Die Anzahl der Spuren 18.1 - 18.n beträgt mindestens 2 und wird nach oben begrenzt bspw. durch die maximale Breite bestimmter Anlagenteile, wie Diffusionsofen, etc.

Der dritte Anlagenteil 16 ist in gleicher Weise aufgebaut und umfasst eine Transporteinrichtung 13, die die Zellen 20 inline in mehreren Spuren transportiert.

An dieser Stelle sei jedoch angemerkt, dass dieser Anlagenteil 16 durch andere Anlagenteile, die bspw. die Zellen inline in einer Spur transportieren, ersetzbar wäre.

Bei dem zweiten Anlagenteil 14 handelt es sich um einen Teil, bei dem die Zellen im sog. Batch-Verfahren transportiert werden. Das bedeutet, dass die Zellen 20 nicht in mehreren Spuren und hintereinander kontinuierlich, sondern dass eine bestimmte Anzahl von Zellen in einen Träger 50 eingehordet und dann zusammen mit dem Träger durch den Anlagenteil 14 transportiert werden.

Der Anlagenteil 14 kann bspw. ein oder mehrere Becken 22 aufweisen, das bspw. ein Mittel zur alkalischen Oberflächenstrukturierung enthält. An dieser Stelle sei jedoch angemerkt, dass die vorliegende Erfindung nicht auf diese Art der Behandlung beschränkt ist. Der zweite Anlagenteil 14 kann auch Einheiten zur Ausführung anderer sog. Batch-Verfahren umfassen. Hierzu zählen, um nur einige wenige zu nennen, galvanische Verfahren, Reinigungs- oder Spülvorgänge, etc. Der zweite Anlagenteil 14 steht grundsätzlich allgemein für jeden Anlagenteil einer Produktionsanlage zur Herstellung von Solarzellen, bei dem die Zellen in einem Träger im Batch-Verfahren hindurchgeführt werden.

Die in Fig. 1 gezeigte Produktionsanlage 10 umfasst im Übergang vom ersten Anlagenteil 12 zum zweiten Anlagenteil 12, 14 eine Inline-Batch-Umsetzeinrichtung 30 und zwischen zweitem Anlagenteil 14 und drittem Anlagenteil 16 eine Batch-Inline-Umsetzeinrichtung 40.

Die Inline-Batch-Umsetzeinrichtung 30 ist dazu ausgebildet und vorgesehen, Zellen 20 mehrerer Spuren 18.1 - 18.n in einem Träger 50 einzuhorden. Hierfür weist der Träger 50 eine der Anzahl der Spuren n entsprechende Anzahl von Fächern 51.1 - 51.n auf, die sich senkrecht zur Zeichenebene erstrecken und die in dieser Richtung mehrere Zellen gestapelt aber mit Abstand zueinander aufnehmen können.

Die Inline-Batch-Umsetzeinrichtung 30 ist ferner dazu ausgelegt, einen Träger 50 an den zweiten Anlagenteil 14 zu übergeben, so dass dieser Träger 50 durch diesen Anlagenteil hindurchgeführt werden kann.

Die Batch-Inline-Umsetzeinrichtung 40 ist dafür vorgesehen, den Träger 50 vom zweiten Anlagenteil 14 zu übernehmen und die in den Fächern 51.1 - 51.n gestapelten Zellen dem nachfolgenden dritten Anlagenteil 16 zu übergeben.

Mit Hilfe der beiden Umsetzeinrichtungen 30, 40 ist es möglich, einen Anlagenteil 14 in eine Anlage für Inline-Prozesse zu integrieren, der einen Batchprozess ausführen kann.

Soll aus bestimmten Gründen der zweite Anlagenteil 14 einer Produktionsanlage 10 nicht eingesetzt werden, ist eine Bypass-Transporteinrichtung 32 vorgesehen, die manuell oder automatisiert in die Anlage eingebracht wird, um den zweiten Anlagenteil 14 zu überbrücken. Dies ist in Fig. 1 mit der unteren Darstellung gezeigt. Diese Bypass-Transporteinrichtung 32 ist aufgebaut wie die Transporteinrichtung 13, so dass die Zellen 20 mehrspurig im Inline-Verfahren zu dem dritten Anlagenteil 16 transportiert werden und dabei nicht das Becken 22 durchqueren. Obgleich in Fig.1 die Bypass-Transporteinrichtung 32 bis zu den Anlagenteilen 12 und 16 reicht, wäre es auch denkbar, die Länge der Bypass-Transporteinrichtung an die Länge des/der Becken(s) anzupassen und dafür die Transporteinrichtungen 13 zu verlängern.

Der zuvor beschriebene Anlagenaufbau mit Inline-Batch-Umsetzeinrichtung 30, Batch-Inline-Umsetzeinrichtung 40 und Bypass-Transporteinrichtung 32 ist besonders dann vorteilhaft, wenn in einer Produktionsanlage sowohl eine saure Oberflächenstrukturierung der Zellen im Inline-Verfahren als auch eine alkalische Oberflächenstrukturierung im Batch-Verfahren durchgeführt werden sollen. Bisher war es nur unter Wirkungsgradeinbußen möglich, die Strukturierung von monokristallinen Wafern und die saure Strukturierung von multikristallinen Wafern in einer mehrspurigen Inline-Produktionsanlage auszuführen.

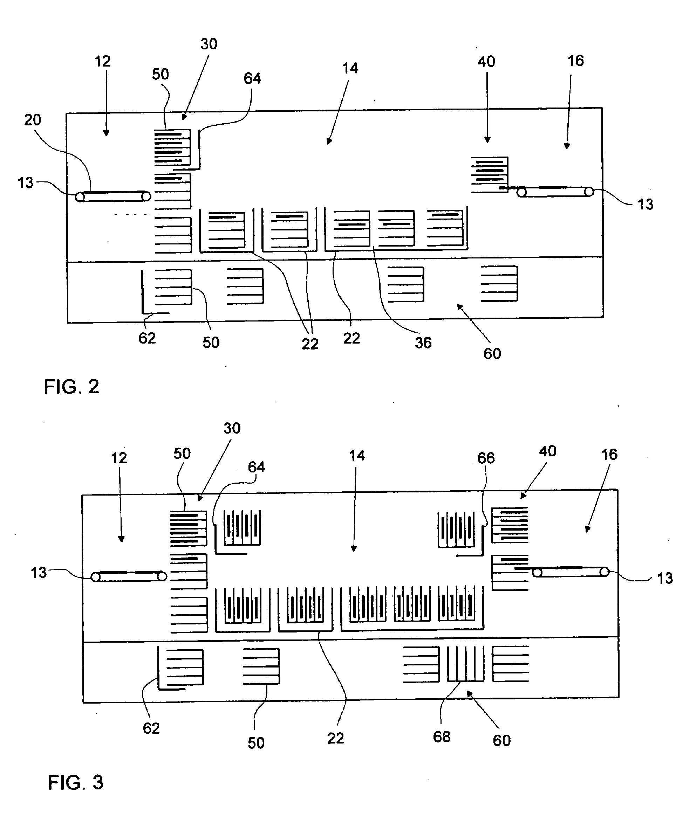

In Fig. 2 ist die Produktionsanlage 10 von Fig. 1 in einer Seitenansicht schematisch dargestellt. Zu erkennen sind hierbei insbesondere die Transporteinrichtungen 13 des ersten und des dritten Anlagenteils 16 und der zweite Anlagenteil 14, der im vorliegenden Ausführungsbeispiel drei Becken zur Behandlung der Zellen 20 aufweist. Im Bereich zwischen dem ersten und dem zweiten Anlagenteil 12, 14 ist die Inline-Batch-Umsetzeinrichtung 30 vorgesehen, die von einer unteren Ebene Träger 50 über eine Hubeinrichtung 62 senkrecht nach oben fördert. Auf diese Weise können die Zellen 20 der Spuren 18.1 - 18.n in den Träger 50 eintransportiert werden. Sobald die Zellen im Träger 50 sind, hebt die Hubeinrichtung 62 die Träger um eine Position (Abstand zwischen benachbarten Zellen in einem Fach 51 des Trägers) nach oben. Dieses getaktete Einbringen von Zellen und Anheben des Trägers wird solange wiederholt, bis der Träger 50 voll ist.

Zur Übergabe eines vollen Trägers 50 an den zweiten Anlagenteil 14 ist eine Umsetzeinheit 64 vorgesehen, die in Fig. 2 nur schematisch dargestellt ist. Die Umsetzeinheit 64 nimmt den vollen Träger 50 und übergibt ihn entweder direkt an ein nachfolgendes Handlingssystem, das dem zweiten Anlagenteil zugeordnet ist oder setzt ihn bspw. direkt in das erste Becken 22. Selbstverständlich sind auch andere Lösungen zur Übergabe des Trägers an den nachfolgenden Anlagenteil denkbar. Die vorliegende Erfindung soll sich nicht auf einzelne Ausgestaltungen beschränken. Innerhalb des zweiten Anlagenteils 14 wird ein Träger 50 mit den eingestapelten Zellen durch ein oder mehrere Becken 22 im Batch-Verfahren hin durchgeführt, wobei die vorliegende Erfindung nicht auf bestimmte Prozesse innerhalb des zweiten Anlagenteils 14 beschränkt ist. Vielmehr sind beliebige Prozesse ausführbar, die im Batch-Verfahren möglich sind. Dazu gehören u.a. auch galvanische Verfahren, Reinigungs- und Spülverfahren, Trocknungsprozesse, und dergleichen.

An dieser Stelle sei noch darauf hingewiesen, dass innerhalb des - in Transportrichtung gesehen - letzten Beckens 22 im zweiten Anlagenteil 14 eine Transporteinheit 36 vorgesehen ist, die einen Träger 50 in Transportrichtung durch das Becken 22 fördert. Erst bei Erreichen des Endes des Beckens 22 wird über eine - nicht dargestellte - Transporteinrichtung der Träger entnommen und der sich anschließenden Batch-Inline-Umsetzeinrichtung 40 übergeben.

In dieser Batch-Inline-Umsetzeinrichtung 40 ist wiederum eine Hubeinrichtung vorgesehen, die aus Übersichtlichkeitsgründen jedoch nicht dargestellt ist. Diese Hubeinrichtung dient dazu, den Träger 50 getaktet um eine Position nach unten zu führen, um jeweils die Zellen in den Fächern einer Ebene zu entnehmen. Diese Zellen gelangen auf die Transporteinrichtung 13 des dritten Anlagenteils 16 und werden dann mehrspurig im Inline-Verfahren zu den nachfolgenden Stationen transportiert.

Die entleerten Träger 50 in der Batch-Inline-Umsetzeinrichtung 40 gelangen wieder zurück zu der Hubeinrichtung 62 der Inline-Batch-Umsetzeinrichtung 30, wobei hierfür eine Rücktransporteinrichtung 60 vorgesehen ist, die in den Figuren jedoch nicht detailliert ausgeführt ist. Bei der Rücktransporteinrichtung 60 kann es sich bspw. um ein Band oder Rollentransportsystem handeln, auf dem die leeren Träger 50 in einer Ebene zurückgeführt werden. Bevorzugt wird beim Rücktransport der Träger deren Reinigung über ein -nicht dargestelltes- Reinigungssystem durchgeführt.

Bei einigen Batchprozessen ist es vorteilhaft, die Zellen nicht in einer horizontalen Position - wie in Beispiel von Fig. 2 - sondern vielmehr in einer vertikalen Position zu halten. Um dies zu erreichen, wird bei dem in Fig. 3 gezeigten Ausführungsbeispiel ein Träger 50 bei der Übergabe in den zweiten Anlagenteil 14 um 90° gekippt bzw. gedreht, so dass die Zellen dann senkrecht stehen. Die Umsetzeinheit 64 kann diesen zusätzlich Schritt bei der Übergabe ausführen.

Bei der Übergabe des Trägers 50 mit den vertikalen Zellen an die Batch-Inline-Umsetzeinrichtung ist es nun erforderlich, den Träger wiederum um 90° zu drehen bzw. zu kippen, so dass die Zellen in der gewünschten horizontalen Lage sind und entnommen werden können. Dieses Schwenken um 90° wird von der schematisch angedeuteten Übergabeeinrichtung 66 übernommen.

Schließlich ist im Unterschied zu der Ausführungsform gemäß Fig. 2 bei der in Fig. 3 gezeigten Ausführungsbeispiel beim Rücktransport ein Schwenken des Trägers um 180° erforderlich, was über eine Schwenkeinrichtung 68 im Bereich der Rücktransporteinrichtung 60 ausgeführt wird.

Ansonsten ist die Funktionsweise der Inline-Batch und der Batch-Inline-Umsetzeinrichtungen 30, 40 gleich, so dass darauf nicht weiter eingegangen werden muss.

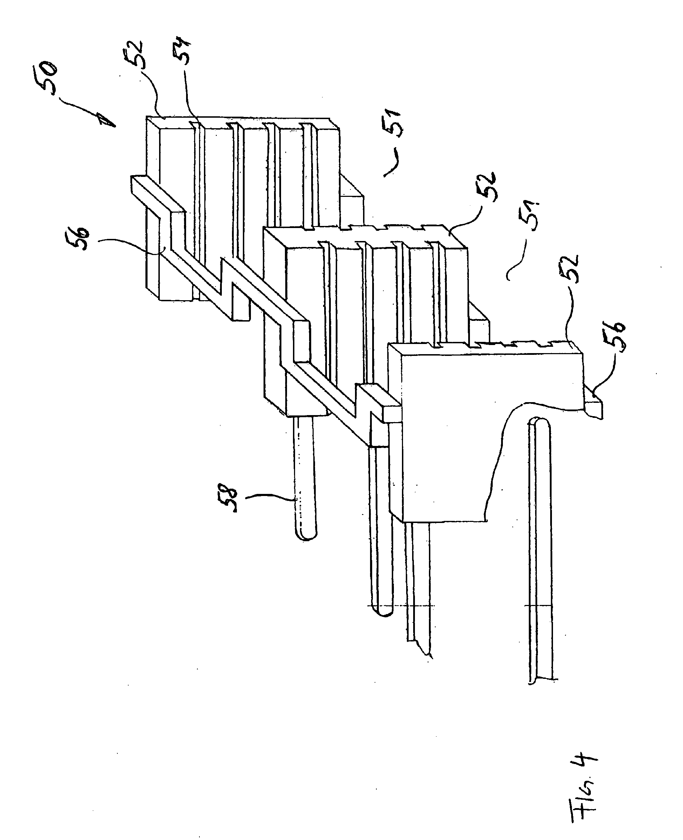

In Fig. 4 ist ein Träger 50 in perspektivischer Darstellung ausschnittsweise gezeigt. Zu erkennen ist in Fig. 4, dass der Träger 50 mehrere Seitenteile 52 aufweist (im vorliegenden Ausführungsbeispiel 3), die zwischen sich die Fächer 51 zur Aufnahme von Zellen bilden.

Die Seitenwände 52 werden über Träger 56 gehalten, wobei nur beispielhaft ein Träger 56 zu sehen ist.

In den Seitenwänden 52 sind im Bereich der Fächer 51 Nuten 54 vorgesehen, deren Abmessungen an die Dicke der Zellen angepasst ist. Die Nuten 54 sind randoffen ausgebildet und erstrecken sich über die gesamte Länge (in Transportrichtung gesehen) der Seitenteile 52. Zudem sind die gegenüberliegenden Nuten 54 in jedem Fach 51 zueinander ausgerichtet, so dass die in zwei Nuten eingebrachte Zelle eben liegt.

Zudem sind die Nuten benachbarter Fächer 51 ebenfalls zueinander ausgerichtet.

Abhängig von den eingesetzten Batchprozessen ist der gesamte Träger 50 aus Metall, Quarzglas, Kunststoff oder Keramik gefertigt.

Im Bereich der Umsetzeinrichtungen 30, 40 ist eine Transporteinrichtung 58 vorgesehen, die in Fig. 4 schematisch angedeutet ist. Diese Transporteinrichtung 58 dient dazu, die Zellen in den Träger 50, insbesondere in die entsprechenden Nuten 54 einzuschieben. Neben den in Fig. 4 angedeuteten Bändern als Transporteinrichtung 58 sind auch andere Transportelemente denkbar, wobei allerdings sicherzustellen ist, dass die Beschädigungsgefahr beim Einbringen von Solarzellen in den Träger 50 möglichst gering ist.

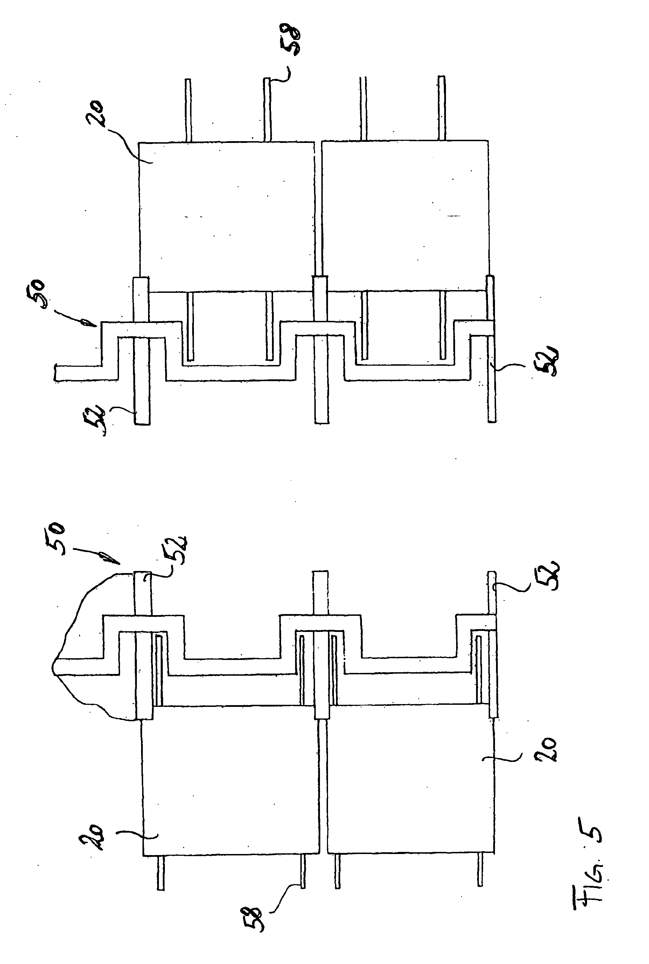

In Fig. 5 ist der Ein- der Austransport von Zellen in den Träger 50 nochmals deutlicher in Draufsicht dargestellt.

Die Zellen 20 werden über die Transporteinrichtung 58 mehrspurig und gleichzeitig in die einzelnen Fächer 51 des Trägers 50 transportiert und im Träger selbst von den Nuten 54 gestützt.

In der Batch-Inline-Umsetzeinrichtung 40 können die Zellen wieder über entsprechende Transporteinrichtungen 58 aus dem Träger 50 austransportiert werden, wobei hierfür ein Drehen des Trägers nicht erforderlich ist. Dies wird dadurch erreicht, dass der Träger von zwei Seiten beladbar ist, wie sich sehr deutlich aus der Darstellung von Fig. 4 ergibt.

Insgesamt ist somit festzustellen, dass die vorliegende Erfindung eine Möglichkeit schafft, in einfacher Weise einen Batchprozess in eine Inline-Produktionsanlage für

Solarzellen zu integrieren. Es ist lediglich erforderlich, die beiden Umsetzeinrichtungen 30, 40 vor und nach dem Anlagenteil für den Batchprozess vorzusehen. Sollte der Batchprozess einmal nicht erforderlich sein, kann mit Hilfe der Bypass-Transporteinrichtung 32 dieser Anlagenteil überbrückt werden.

Durch die Kombination von Inline- und Batchprozessen in einer Produktionsanlage können die Investitionskosten gering gehalten werden, ohne dass sich der Nutzer auf die Bearbeitung bspw. von monokristallinen oder multikristallinen Wafern beschränken müsste. Zudem bringt der horizontale Transport der Zellen durch den Batchprozess den Vorteil, dass der Druck auf die Kanten der Zellen klein gehalten und damit die Bruchgefahr verringert werden kann.

Am Ende sei noch darauf hingewiesen, dass die Erfindung unabhängig von der Art und dem Aufbau des zweiten Anlagenteils 14 ist. Darüber hinaus ist die Erfindung auch nicht auf Produktionsanlagen beschränkt, bei der der dritte Anlagenteil 16 mehrspurig ist. Vielmehr wäre auch denkbar, in diesem Bereich die Zellen einspurig im Inline-Verfahren weiterzutransportieren.

## Patentansprüche

1. Produktionsanlage zur Herstellung von Solarzellen im Inline-Verfahren,
mit einer Transporteinrichtung (13) zum Transport von einzelnen Zellen (20) in mehreren parallelen Spuren (18.1 - 18.n),
einer Inline-Batch-Umsetzvorrichtung (30), die ausgelegt ist, Zellen (20) aus den parallelen Spuren (18.1. - 18.n) gleichzeitig in einen Träger (50) einzubringen und
die Zellen (20) jeweils einer Spur (18) übereinander in diesen Träger (50) einzustapeln, und
einer Batch-Inline-Umsetzvorrichtung (40), die ausgelegt ist, die Zellen (20) aus diesem Träger (50) auszubringen und auf zumindest eine Spur (18) einer Transporteinrichtung (13) zu führen.

2. Produktionsanlage nach Anspruch 1, **dadurch gekennzeichnet dass** zwischen Inline-Batch- (30) und Batch-Inline-Umsetzvorrichtung (40) ein Anlagenteil (14) zur Ausführung eines Batchprozesses vorgesehen ist, wobei hierfür der Träger (50) mit den Zellen durch den Anlagenteil transportiert wird.

3. Produktionsanlage nach Anspruch 2, **dadurch gekennzeichnet, dass** dem Batchprozess-Anlagenteil eine Bypass-Transporteinrichtung (32) zugeordnet ist, die zur wahlweisen Überbrückung des Anlagenteils (14) ausgelegt ist, so dass die Zellen keine Behandlung in diesem Anlagenteil (14) erfahren.

4. Produktionsanlage nach Anspruch 3, **dadurch gekennzeichnet, dass** die Bypass-Transporteinrichtung (32) eine Transporteinheit entsprechend der Transporteinrichtung (13) aufweist, um Zellen in mehreren Spuren (18) zu transportieren.

5. Verfahren zur Integration eines Batchprozesses in eine mehrspurige Inline-Produktionsanlage für Solarzellen, mit den Schritten:
gleichzeitige Übergabe von Zellen (20) mehrerer Spuren (18.1 - 18.n) eines In lineprozess-Anlagenteils in einen matrixartig aufgebauten Träger (50),
Anheben oder Absetzen des Trägers (50) um eine Position, und
Wiederholung des Übergabe-Schritts, um mehrere Zellen (20) jeweils einer Spur im Träger (50) zu stapeln, und
Übergabe des Trägers an einen nachfolgenden Batchprozess-Anlagenteil (14);
Übernahme des Trägers (50) am Ende des Batchprozess-Anlagenteils (14),
Positionieren des Trägers (50) relativ zu einer nachfolgenden Transportebene des ein- oder mehrspurigen Inlineprozess-Anlagenteils,
gleichzeitige Übergabe von Zellen (20) aus einer Ebene des Trägers (50) an die eine Spur oder die mehreren Spuren (18.1 - 18.n) des Inlineprozess-Anlagenteils (16),
Absenken oder Anheben des Trägers (50) um eine Position, und
Wiederholung des Übergabeschritts, um alle Zellen (20) jedes Stapels dem nachfolgenden Inlineprozess-Anlagenteil zuzuführen, und
Rückführung des leeren Trägers (50).

6. Verfahren nach Anspruch 5, **dadurch gekennzeichnet, dass** vor der Übergabe an den Batchprozess-Anlagenteil der Träger um 90° gedreht wird.

7. Verfahren nach einem der Ansprüche 5 bis 6, wobei der Batch-Anlagenteil ein Becken zur Behandlung der Zellen aufweist, **dadurch gekennzeichnet, dass** der Träger mit den Zellen durch das Becken gefördert wird.

## Claims

1. Production plant for manufacturing solar cells by using the inline method, having a transport device (13) for transporting individual cells (20) in a number of parallel tracks (18), **characterized by**
an inline batch transfer device (30) which is designed for simultaneously loading cells (20) from the parallel tracks (18.1 - 18.n) into a carrier (50) and stacking the cells (20) of respectively one track (18) one on top of another in the carrier (50), and
a batch inline transfer device (40) which is designed for unloading the cells (20) from the carrier and guiding them onto at least one track (18) of a transport device (13).

2. Production plant according to Claim 1, **characterized in that** a plant part (14) for executing a batch process is provided between inline batch (30) and batch inline transfer device (40), the carrier (50) with the cells being transported for this purpose through the plant part.

3. Production plant according to Claim 2, **characterized in that** the batch process plant part is assigned a bypass transport device (32) which is designed for optionally bridging the plant part (14) so that the cells undergo no treatment in this plant part (14).

4. Production plant according to Claim 3, **characterized in that** the bypass transport device (32) has a transport unit corresponding to the transport device (13) in order to transport cells in a number of tracks (18).

5. Method for integrating a batch process into a multitrack inline production plant for solar cells, having the steps of:
simultaneously handing over cells (20) of a number of tracks (18.1 - 18.n) of an inline process plant part into a carrier (50) formed like a matrix,
raising or lowering the carrier (50) by one position,
repeating the handover step in order to stack a number of cells 20) of in each case one track in the carrier,
handing over the carrier to a subsequent batch process plant part (14),
taking over the carrier (50) at the end of the batch process plant part (14),
positioning the carrier (50) relative to a subsequent transport plane on the single-track or multitrack inline process plant part,
simultaneously handing over cells (20) from a plane of the carrier to the one track or the number of tracks of the inline process plant part,
lowering or raising the carrier (50) by one position, and
repeating the handover step in order to feed all the cells (20) of each stack to the subsequent inline process plant part, and
returning the empty carrier (50).

6. Method according to Claim 5, **characterized in that** the carrier is rotated by 90° before the handover to the batch process plant part.

7. Method according to one of Claims 5 to 6, the batch plant part having a tank for treating the cells, **characterized in that** the carrier with the cells is conveyed through the tank.

## Revendications

1. Installation de production pour la fabrication de cellules solaires dans un procédé en ligne, comprenant un dispositif de transport (13) pour le transport de cellules individuelles (20) dans plusieurs voies parallèles (18.1 - 18.n),
un dispositif de conversion en ligne/discontinu (30) qui est conçu pour introduire des cellules (20) provenant des voies parallèles (18.1 - 18.n) simultanément dans un support (50) et
empiler les unes sur les autres les cellules (20) d'une voie respective (18) dans ce support (50), et
un dispositif de conversion discontinu/en ligne (40) qui est conçu pour faire sortir les cellules (20) hors de ce support (50) et les guider sur au moins une voie (18) d'un dispositif de transport (13).

2. Installation de production selon la revendication 1, **caractérisée en ce qu'**une partie d'installation (14) pour mettre en oeuvre un processus discontinu est prévue entre le dispositif de conversion en ligne/discontinu (30) et le dispositif de conversion discontinu/en ligne (40), le support (50) comprenant les cellules étant à cet effet transporté à travers la partie d'installation.

3. Installation de production selon la revendication 2, **caractérisée en ce qu'**un dispositif de transport de dérivation (32) est associé à la partie d'installation de processus discontinu, lequel dispositif de transport de dérivation est conçu pour surmonter de manière sélective la partie d'installation (14), de sorte que les cellules ne soient sujettes à aucun traitement dans cette partie d'installation (14).

4. Installation de production selon la revendication 3, **caractérisée en ce que** le dispositif de transport de dérivation (32) comprend une unité de transport correspondant au dispositif de transport (13), afin de transporter des cellules dans plusieurs voies (18).

5. Procédé d'intégration d'un processus discontinu dans une installation de production en ligne à plusieurs voies pour cellules solaires, comprenant les étapes suivantes :
transfert simultané de cellules (20) de plusieurs voies (18.1 - 18.n) d'une partie d'installation de processus en ligne dans un support (50) conçu sous forme de matrice,
soulèvement ou abaissement du support (50) autour d'une position, et
répétition de l'étape de transfert, afin d'empiler plusieurs cellules (20) d'une voie respective dans le support (50), et
transfert du support à une partie d'installation de processus discontinu (14) suivante ;
transfert du support (50) à l'extrémité de la partie d'installation de processus discontinu (14),
positionnement du support (50) par rapport à un plan de transport suivant de la partie d'installation de processus en ligne à une ou plusieurs voies,
transfert simultané de cellules (20) provenant d'un plan du support (50) à la voie ou aux plusieurs voies (18.1 - 18.n) de la partie d'installation de processus en ligne (16),
abaissement ou soulèvement du support (50) autour d'une position, et
répétition de l'étape de transfert, afin d'acheminer toutes les cellules (20) de chaque pile jusqu'à la partie d'installation de processus en ligne suivante, et
retour du support vide (50).

6. Procédé selon la revendication 5, **caractérisé en ce que** le support est tourné de 90° avant le transfert à la partie d'installation de processus discontinu.

7. Procédé selon l'une quelconque des revendications 5 à 6, la partie d'installation de processus discontinu comprenant un bac pour le traitement des cellules, **caractérisé en ce que** le support comprenant les cellules est transporté à travers le bac.
